# NEUE EUROPÄISCHE PATENTSCHRIFT

(11) **EP 0 272 450 B2**
(45) Veröffentlichungstag und Bekanntmachung des Hinweises auf die Entscheidung über den Einspruch: **18.10.1995**
(45) Hinweis auf die Patenterteilung: 30.09.1992
(21) Anmeldenummer: 87116895.1
(22) Anmeldetag: 16.11.1987
(51) Int. Cl.: G01R 31/28

(54) **Gerät zum Prüfen von Leiterplatten**
Device for testing printed circuit boards
Dispositif pour le test de plaquettes de circuit imprimé

(30) Priorität: 18.11.1986 DE 3639361
(43) Veröffentlichungstag der Anmeldung: 29.06.1988
(73) Patentinhaber: Luther & Maelzer GmbH, D-31515 Wunstorf (DE)
(72) Erfinder: Maelzer, Martin, D-3050 Wunstorf (DE)
(74) Vertreter: Mitscherlich, Hans, Dipl.-Ing.

(56) Entgegenhaltungen:
- DE-A- 2 953 596
- DE-A- 3 142 817
- DE-A- 3 405 566
- DE-A- 3 405 567
- DE-A- 3 406 360
- DE-B- 2 163 970
- DE-C- 3 511 821
- GB-A- 1 384 550
- GB-A- 2 085 673
- PATENT ABSTRACTS OF JAPAN, Band 8, Nr. 204 (P-301)[1641], 18. September 1984 & JP-A-59 90065

## Beschreibung

Die Erfindung bezieht sich auf ein Gerät nach dem Oberbegriff des Anspruchs 1.

Es ist erforderlich, daß die zu prüfende Leiterplatte in einer exakten, genau reproduzierbaren Stellung unterhalb des in den meisten Fällen Prüfstifte aufweisenden Adapters angeordnet wird, damit die Kontaktstellen des Adapters, z.B. die Spitzen der Prüfstifte, die ihnen zugeordneten Kontaktstellen bzw. Prüfpunkte an der Leiterplatte genau treffen.

Ein Gerät der eingangs bezeichneten Art ist aus DE-A-3 511 821 bekannt, und ist auch Gegenstand eines älteren Vorschlags der Anmelderin. Bei der Ausgestaltung nach dem älteren Vorschlag der Anmelderin wird die Leiterplatte an der Prüfstelle zwischen rahmenförmigen Führungsschienen zentriert. Es ist deshalb erforderlich, die Abmessungen der zu prüfenden Leiterplatten reproduzierbar gleich zu machen, damit sie genau zwischen die rahmenförmigen Führungsschienen passen. Das Einpassen (Zentrieren bzw. Positionieren) der zu prüfenden Leiterplatten ist mit einem beachtlichen Arbeitsaufwand verbunden. Das gleiche gilt für die genaue Bemessung der rahmenförmigen Führungsschienen und der zu prüfenden Leiterplatten. Bei Abweichungen von den Passmaßen ist ein Einpassen nicht möglich, oder es stellen sich aufgrund sowohl einer nicht eingepaßten Leiterplatte als auch aufgrund eines unzulässig großen Spiels Kontaktierungsschwierigkeiten ein.

Es ist von Seiten der Anmelderin auch schon vorgeschlagen worden, die zu prüfende Leiterplatte an einer von der Prüfstelle entfernten Eingabestelle einzulegen und mittels einer geneigten Rutsche zur Prüfstelle hin zu fördern. Bei dieser Ausgestaltung besteht die Gefahr, daß die Leiterplatte sich während des Rutschens verstellt, wodurch Störungen bei der Aufnahme der Leiterplatte an der Prüfstelle auftreten können.

Aus der DE 31 42 817 A1 ist bekannt, die zu prüfende Leiterplatte mit Hilfe einer Schublade von einer entfernten Eingabestelle zur Prüfstelle zu transportieren. Dabei wird die Leiterplatte innerhalb der Schublade mittels Zentrierstifte, die in Zentrierbohrungen in der Leiterplatte eingreifen, in einer vordefinierten Stellung auch während des Transportes gehalten, so daß ein Verrutschen der Leiterplatte während der Beförderung zur Prüfstelle ausgeschlossen ist. An der Prüfstelle wird die Leiterplatte gegenüber dem Adapter durch vom Adapter hervorstehende Ausrichttungsstifte arretiert, die in entsprechende Ausrichtbuchsen der die Leiterplatte tragende Tragplatte eingreifen. Der Adapter selbst ist austauschbar. Zur Arretierung bzw. Zentrierung des Adapters ist eine weitere Zentriervorrichtung vorgesehen.

Das Prinzip der Zentrierung der Leiterplatte auf einem Förderelement und der anschließende Ausrichtung der Leiterplatte gegenüber dem Prüfadapter ist beispielsweise auch aus der GB 1 384 550 oder der DE-AS 2 163 970 bekannt. Bei diesen Druckschriften ist jedoch der Adapter nicht auswechselbar. Des weiteren können mit diesen Prüfeinrichtungen nur Leiterplatten einer einzigen bestimmten Abmessung geprüft werden.

Der Erfindung liegt die Aufgabe zugrunde, bei einem Gerät der eingangs bezeichneten Art die Zuführung der Leiterplatte bei Gewährleistung einer einfachen und handhabungsfreundlichen Zuführung und Ausrichtung der Leiterplatte gegenüber dem Adapter zu verbessern.

Diese Aufgabe wird durch die Merkmale des Anspruches 1 gelöst.

Die erfindungsgemäße Ausgestaltung ermöglicht eine Überführung der zu prüfenden Leiterplatte von der Einlegestelle zur Prüfstelle zum einen durch eine kontrollierte Förderung bei ggf. vorbestimmbarer Geschwindigkeit, die durch einen entsprechenden Antrieb für den erfindungsgemäßen Förderer vorgegeben werden kann, und zum anderen in einer vorpositionierten Position mittelbar durch eine Tragplatte, in der sie problemlos eingelegt werden kann. Die zu prüfenden Leiterplatte ist gegenüber der Tragplatte schon beim Einlegen der Leiterplatte an der Einlegestelle arretiert bzw. zentriert, so daß ein Verrutschen der Leiterplatte während der Beförderung zur Prüfstelle ausgeschlossen ist. Des weiteren werden an der Prüfstelle sowohl die Leiterplatte als auch der Adapter durch ein und dieselbe Zentriervorrichtung ausgerichtet. Dadurch ist einerseits eine optimale Ausrichtung der Leiterplatte gegenüber dem Adapter gewährleistet; andererseits wird somit eine zusätzliche Zentriervorrichtung für den austauschbaren Adapter überflüssig und kann daher eingespart werden.

Mit Hilfe der erfindungsgemäßen Prüfvorrichtung ist es zudem möglich, daß Leiterplatten unterschiedlicher Abmessung geprüft werden können, da die Zentriervorrichtungen an der Tragplatte und an der Prüfstelle ein Austauschen der Leiterplatten und des Adapters ermöglichen, ohne daß bei einer Änderung der Abmessungen die Zentriervorrichtungen neu angeordnet werden müssen.

In den Ansprüchen 2 bis 24 sind Merkmale enthalten, die zu einfachen, raumsparenden und zweckmäßigen Bauweisen und/oder Bewegungsantrieben bzw. -führungen führen, wodurch bei sicherer und genauer Funktion eine kostengünstige Herstellung möglich ist. Nachfolgend wird die Erfindung anhand von in vereinfachten Zeichnungen dargestellten bevorzugten Ausführungsbeispielen näher erläutert.

Es zeigt
- Fig. 1: in perspektivischer Darstellung ein erfindungsgemäß ausgestaltetes Gerät in aufgeklappter Position seines Halterahmens für eine elektronische Prüfeinrichtung und einen Adapter;
- Fig. 2: das Gerät in der Arbeitsstellung des Halterahmens,
- Fig. 3: eine Tragplatte mit aufgesetzter Leiterplatte in der Draufsicht;
- Fig. 4: einen senkrechten Längsschnitt durch das Gerät in schematischer Darstellung;
- Fig 5: den Teilschnitt IV-IV in Fig. 4.

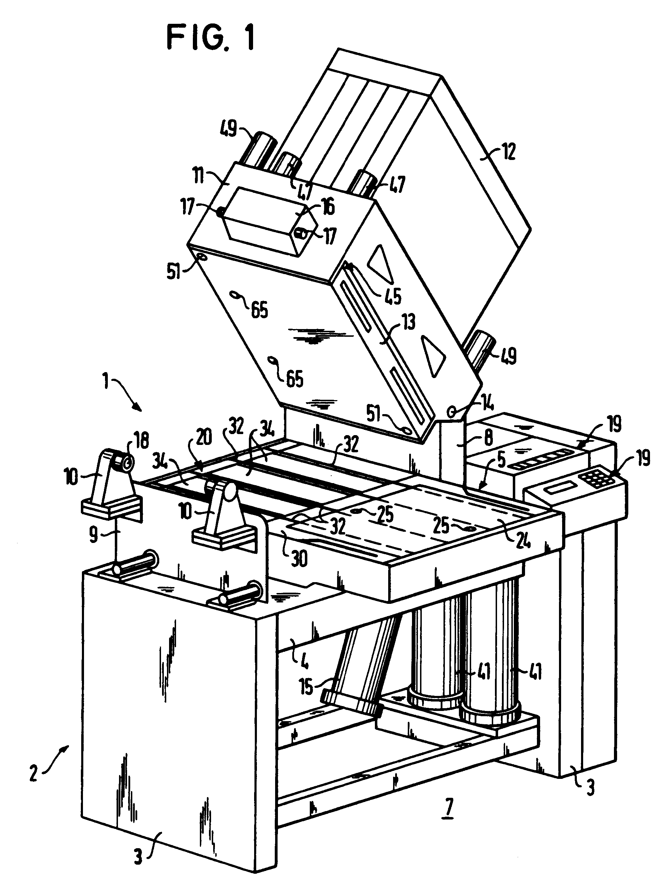

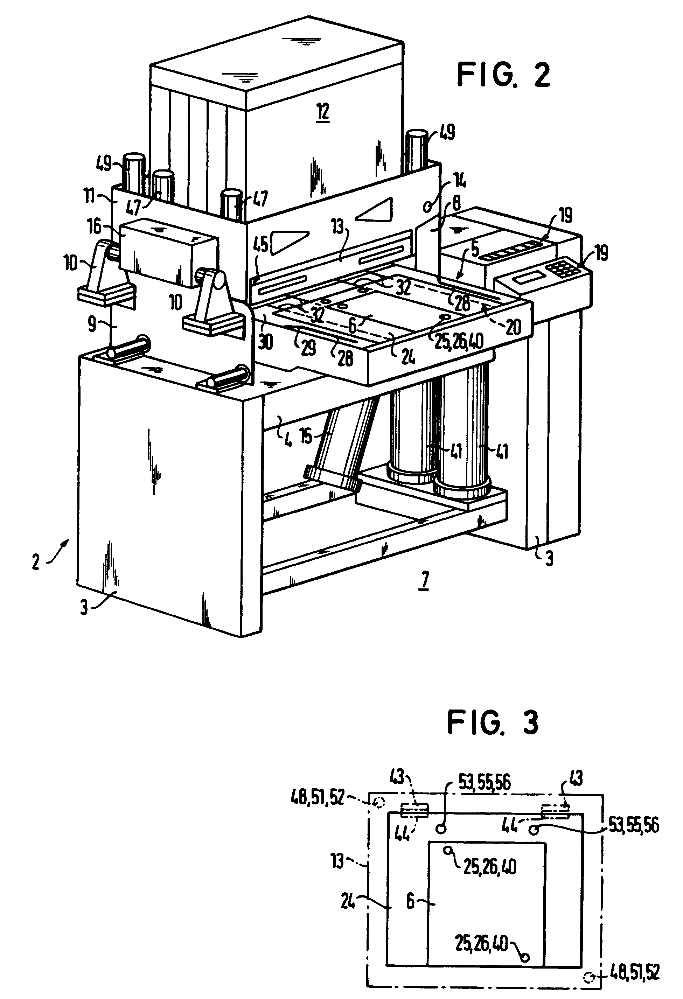

Das in Fig. 1 allgemein mit 1 bezeichnete Gerät weist einen Gestellrahmen 2 mit zwei seitlichen Beinen 3 in Form eines Tisches auf. Auf einer oberen Traverse 4 ist eine ebenfalls tischförmige Aufnahmevorrichtung 5 für zu prüfende, in Fig. 2 dargestellte Leiterplatten 6 angeordnet, die zur Bedienungsseite 7 des Gerätes 1 vorragt. Der Gestellrahmen 2 einerseits und andererseits die Aufnahmevorrichtung 5, ein seitlich rechts angeordneter Lagerblock 8 und eine seitlich links angeordnete Lagerwand 9 mit zwei von der Bedienungsseite 7 her gesehen in einer Höhe hintereinanderliegenden Lagerböcken 10 bilden zwei, durch Bolzen zu einer Baueinheit verbundene Bauteile.

Der mit 11 bezeichnete Halterahmen für die elektronische Prüfeinrichtung 12 und den Adapter 13 ist um eine seitlich rechts horizontal angeordnete Achse 14 mittels einer Zylinderkolbeneinheit 15 zwischen der in Fig. 1 dargestellten hochgeklappten Stellung und der in Fig. 2 dargestellten Arbeitsstellung verschwenkbar. In der Arbeitsstellung ist der Halterahmen 11 durch eine in einen Block 16 integrierte Zylinder-Kolben-Einheit mit zwei einander entgegengesetzt wirksamen Kolben 17 sowohl zentriert als auch fixiert, die in entsprechende Zentrieraufnahmen 18 der Lagerböcke 10 einfassen.

Mit 19 sind Bedienungstastaturen bzw. elektrische Steuergeräte bezeichnet.

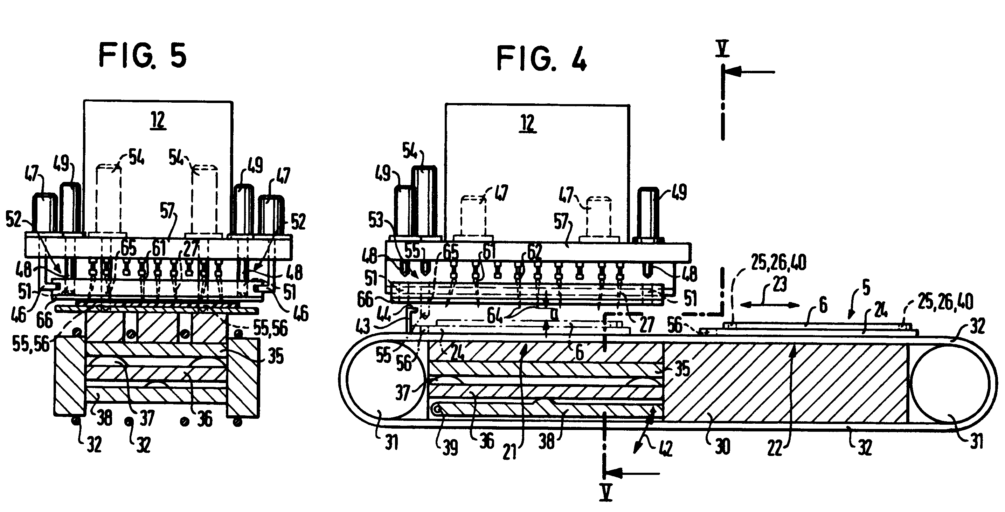

Die Aufnahmevorrichtung 5 weist einen allgemein mit 20 bezeichneten Förderer auf, mit dem die Leiterplatte 6 zwischen einer in Fig. 4 allgemein mit 21 bezeichneten Prüfstelle und einer gegenüber dieser zur Bedienungsseite 7 hin versetzten Eingabestelle 22 hin und her verschiebbar ist. Die Verschieberichtungen sind durch den Doppelpfeil 23 dargestellt. Die Verschiebung der Leiterplatte 6 erfolgt auf einer Tragplatte 24, mit größerer Länge und Breite als die Leiterplatte 6. Die Tragplatte 24 weist einander im wesentlichen diagonal gegenüberliegende aufwärts gerichtete Zentrierzapfen 25 auf, die an der Tragplatte 24 durch Einstecken, Kleben oder auch einstückige Anformung befestigt sein können, und die in entsprechend bemessende Zentrierlöcher 26 in der Leiterplatte 6 einfassen. Der Querschnitt der Zentrierzapfen 25 und der Zentrierlöcher 26 ist vorzugsweise rund. Die Zentrierzapfen 25 sind vorzugsweise so angeordnet, daß sie im Flächenbereich der kleinsten Leiterplatte liegen, so daß sowohl kleine als auch große Leiterplatten mit ein und denselben Zentrierzapfen 25 und -löchern 26 zentriert werden können. Das Auflegen der jeweiligen Leiterplatte 6 ist unproblematisch, da sie an ihrem Umfang in einfacher Weise gehalten, bzw. geleitet werden kann und die Zentrierzapfen außerdem Schrägflächen, z.B. in Form einer kegel- bzw. kegelstumpfförmigen Anspitzung (nicht dargestellt) aufweisen können.

An der Eingabestelle 22 sind die Leiterplatte 6 und die Tragplatte 24 in Fig. 4 sichtbar dargestellt, während sie an der Prüfstelle 21 durch Strichpunktlinien andeutungsweise dargestellt sind. Die Anordnung ist so getroffen, daß zwischen dem Adapter 13, d.h. zwischen seinen Kontaktstellen, die beim vorliegenden Ausführungsbeispiel durch die Spitzen von Prüfstiften 27 gebildet sind, ein Abstand a besteht.

Seitlich neben der Tragplatte 24 befinden sich Vorpositionierungsglieder bzw. -kanten 28 mit vorzugsweise Einlaufschrägen 29, die durch auf einer Platte 30 der Aunahmevorrichtung 5 befestigte Leisten gebildet sein können, und die die Tragplatte 24 mit seitlichem Spiel begrenzen.

Der Förderer 20 wird durch endlose, um Rollen 31 oder Walzen umlaufende Förderbänder 32 gebildet, von denen beim vorliegenden Ausführungsbeispiel vier Stück in einem Abstand voneinander angeordnet sind und auf horizontalen Platte 30 der Aufnahmevorrichtung 5 gleiten. Ein auf wenigstens eine Rolle 31 wirksamer Antrieb für den Förderer 20 ist Vereinfachungsgründen nicht dargestellt.

In der Platte 33 sind im Bereich der Prüfstelle 21 drei Druckleisten 34 senkrecht verschiebbar eingelassen, die auf einer ersten Druckplatte 35 angeordnet sind. Unterhalb der ersten Druckpaltte 35 befindet sich eine zweite Durckplatte 36, wobei zwischen der ersten und der zweiten Druckplatte 35, 36 vier Stück an sich bekannte Durckbälge 37 im Bereich Ecken der Druckplatten 35, 36 angeordnet sind. Unterhalb der zweiten Druckplatte 36 befindet sich ein Durckglied 38, das um eine Achse 39 (Fig. 4) mittels der nur in Fig. 1 und 2 teilweise dargestellten Zylinder-Kolbeneinheiten 41 in Richtung des Doppelpfeiles 42 schwenkbar ist.

Auf der der Eingabestelle 22 abgewandten Seite sind der Prüfstelle 21 ein oder zwei Anschläge 43 für die Tragplatte 24 zugeordnet, die auf der Platte 30 oder den Druckleisten 34 befestigt sein können und die Tragplatte 24 mit hakenförmigen Ansätzen 44, übergreifen. Wenn die Anschläge an der Platte 30 befestigt sind bedarf es eines vertikalen Abstandes zwischen den Ansätzen 44 und der Tragplatte 24, das wenigstens dem vertikalen Hub der Tragplatte 24 entspricht.

Der Adapter 13 ist einer allgemein mit 45 bezeichneten Adapter-Führung aufgenommen, die schubladenförmig ausgebildet ist, und in die der Adapter 13 von der Bedienungsseite 7 her einsteckbar ist. Die in den Fig. 4 und 5 andeutungsweise dargestellten Führungsleisten 46 der Führung 45 sind durch vier seitlich angeordnete Zylinder-Kolbeneinheiten 47 gemeinsam vertikal verschiebbar und zwar zwischen einer tiefer gelegenen Verschiebeposition und einer höher gelegenen zentrierten und fixierten Arbeitsposition. Der Hub beträgt etwa 10 mm. Die Zentrierung des Adapters 13 erfolgt durch zwei einander diagonal gegenüberliegende zylindrische, kegelförmig angespitzte Zentrierbolzen 48, die sich vertikal erstrekken und jeweils durch eine Zylinderkolbeneinheit 49 zwischen einer hochgezogenen Freigabestellung und einer in ein entsprechend geformtes Zentrierloch 51 im Adapter 13 heruntergeschobenen Zentrierstellung verschiebbar sind. Gemäß Fig. 4 befinden sich die Zentrierbolzen 48 in ihrer Freigabestellung, während sie gemäß Fig. 5 sich in ihrer in den Adapter 13 eingeschobenen Zentrierstellung befinden. Diese Zentriervorrichtung ist allgemein mit 52 bezeichnet.

Im Bereich der Prüfstelle 21 ist auch eine allgemein mit 53 bezeichnete Zentriervorrichtung vorgesehen, bestehend aus ebenfalls zwei zylindrischen, jeweils mittels einer Zylinderkolbeneinheit 54 axial und senkrecht verschiebbarer Zentrierbolzen 55, deren nach unten weisende freie Enden ebenfalls kegelförmig angespitzt sind, und die zur Zentrierung der Tragplatte 24 an der Prüfstelle 21 dienen. In ihrer Freigabestellung befinden sich die Zentrierbolzen 55 oberhalb der Tragplatte 24 (s. gestrichelte Darstellung in Fig. 4), und sie sind in ihrer Zentrierstellung aktiv oder passiv in entsprechend geformte Zentrierlöcher 56 in der Tragplatte 24 verschoben (Fig. 5). Aus Raumersparnisgründen sind die Zentrierbolzen 55 an der Rückseite des Halterahmens 11 bzw. der Tragplatte 24 angeordnet, so daß in Fig. 4 nur ein Zentrierbolzen 55 sichtbar ist. Die Zuordnung der Zentriervorrichtungen und der Anschläge 43 ist gemäß Fig. 3 in der Draufsicht erkennbar.

Die Zylinderkolbeneinheiten 47, 49 und 54 bzw. die zugeordneten Führungsleisten 46 und Zentrierbolzen 48 sowie 55 bzw. deren bewegliche Elemente können in vorteilhafter Weise an einer horizontalen Trägerplatte 57 zentriert bzw. geführt sein, die am Halterahmen 11 befestigt ist und auch die elektronische Prüfeinrichtung 12 trägt, die gegenüber der Trägerplatte 52 zentriert und fixiert ist.

Im folgenden wird die Funktion des Gerätes 1 beschrieben.

Da zum vorliegenden Gerät 1 austauschbare Adapter 13 gehören, wird zunächst davon ausgegangen, daß ein passender Adapter 13 einzusetzen ist. Hierfür wird der Adapter 13 in seine Führung 45 eingeschoben, wobei Zentrierbolzen 48, 55 sich in ihrer hochgeschobenen Position und die die Führungsleisten 46 sich in ihrer unteren Position befinden. Letzteres ist erforderlich, weil sich die mit 61 bezeichneten Köpfe, vorzugsweise Kugelköpfe, der Prüfstifte 27 beim Einschieben und auch Herausziehen des Adapters 13 unterhalb von Kontaktelementen in Form von Kontaktkronen 62 der elektronischen Prüfeinrichtung 12, die die Trägerplatte 57 durchfassen, befinden müssen. In der eingeschobenen Position wird der Adapter 13 mittels der Zylinderkolbeneinheiten 47 soweit hochgezogen, daß die Köpfe 61 die Kontaktkronen 62 kontaktieren, wobei die Kontaktkronen 62 gegen eine Federkraft (nicht dargestellt) geringfügig eingeschoben werden. In dieser Position wird der Adapter 13 durch Herunterschieben der Zentrierbolzen 48 zentriert und in nicht dargestellter Weise fixiert.

Zum Prüfen einer Leiterplatte 6 wird diese an der Eingabestelle 22 auf die sich dort befindliche Tragplatte 24 aufgelegt und gleichzeitig durch die Zentrierzapfen 25 und -löcher 26 zentriert, die eine allgemein mit 40 bezeichnete Zentriervorrichtung bilden. Die Tragplatte selbst ist dabei durch die Vorpositionierungskanten 28 mit seitlichem Bewegungsspiel vorpositioniert. In dieser Position wird die Tragplatte 24 mit der Leiterplatte 6 durch den Förderer 20 zur Prüfstelle 22, vorbewegt. Es ist möglich, den Förderweg im Rahmen der Vorpositionierung zu bestimmen, oder die Tragplatte 24 gegen die Anschläge 43 zu schieben und vorzupositionieren. Danach werden die Druckleisten 34 durch Betätigung der Zylinderkolbeneinheiten 41 hochgefahren, wobei das Druckglied 31 mittels einer mittigen Erhebung im wesentlichen zentrisch gegen die zweite Druckplatte 36 drückt, die über die vier Druckbälge 37 gleichmäßig gegen die erste Druckplatte 35 und somit gegen die Druckleisten 34 wirkt. Die Druckleisten 34 können hochgefahren werden, weil zwischen der mittleren und der jeweils äußeren der drei Druckleisten 34 ein Abstand vorhanden ist, in den die beiden mittleren Förderbänder 32 passiv eintauchen. An den beiden äußeren Förderbändern 32 bewegen sich die äußeren Druckleisten 34 vorbei. Mittels der hochfahrenden Druckleisten 34 werden die Tragplatte 24 und die Leiterplatte 6 soweit angehoben, daß die Spitzen 64 der Prüfstifte 27 die nicht dargestellten Prüfpunkte der Leiterplatte 6 kontaktieren (Fig. 5). Das Hochfahren kann soweit erfolgen, daß die Leiterplatte 6 mit ihrer Oberseite an der Unterseite des Adapters 13 anliegt, wobei die Prüfstifte 27 und die Kontaktkronen 62 hochbewegt werden. Während des Hochfahrens oder danach erfolgt die Zentrierung der Tragplatte 24 durch das Herunterschieben der Zentrierbolzen 55 in die Zentrierlöcher 56 oder ein Aufschieben letzterer auf in diesem Falle nicht verschobene Zentrierbolzen 55. In dieser hochgefahrenen Position der Leiterplatte 6 erfolgt die Prüfung.

Anschließend wird die Leiterplatte 6 durch ein Herunterschwenken des Druckgliedes 38 heruntergefahren, bis die Tragplatte 24 auf den Förderbändern 32 aufliegt, wobei die Zentrierbolzen 55 aktiv oder passiv aus den Zentrierlöchern 56 herausgezogen werden. Die Ansätze 44 können hierbei Abstreifer fungieren. Danach erfolgt die Rückführung der Tragplatte 24 mittels des Förderers 20 zur Eingabestelle 22, wo die Leiterplatte 6 entnommen werden kann.

Die Eingabe und oder die Entnahme der Leiterplatte 6 kann manuell oder auch durch eine Vorrichtung automatisch erfolgen.

Ein bedeutendes Merkmal der Zentriervorrichtung 53 besteht auch noch darin, daß die Zentrierbolzen 55 gleichzeitig den Adapter 13 in entsprechend geformten Zentrierlöchern 65 durchfassen. Es ist in diesem Falle vorteilhaft, eine unterste Führungsplatte 66 des aus mehreren übereinander angeordneten Führungsplatten bestehenden Adapters 13 (nicht dargestellt) bezüglich der Zentrierlöcher 56 und 65 gleichzeitig zu bohren, so daß sich eine genaue Indexierung des Adapters 13 gegenüber der Tragplatte 24 und somit auch der Leiterplatte 6 ergibt.

Es ist im Rahmen der Erfindung auch möglich, die Zentrierbolzen 48 zur Zentrierung der Tragplatte 24 heranzuziehen, wobei es lediglich einer entsprechenden Anordnung von Zentrierlöcher in der Tragplatte 24 und einer entsprechenden Hublänge sowie Steuerung der Zylinderkolbeneinheiten 49 bedarf. Beim zuerst beschriebenen Ausführungsbeipsiel ist die zusätzliche Zentriervorrichtung 53 aus Gründen der Raumausnutzung und aus steuerungstechnischen Gründen vorgesehen.

## Patentansprüche

1. Gerät zum Prüfen von in und/oder außer Raster angeordneten Prüfpunkten einer Leiterplatte mittels eines austauschbaren Adapters (13), der während der Prüfung zwischen Kontaktelementen (62) einer elektronischen Prüfeinrichtung (12) und der an einer Prüfstelle (21) befindlichen Leiterplatte (6) angeordnet ist,
mit einer tischförmigen Aufnahmevorrichtung (5) für die Leiterplatte (6),
mit einem darüber angeordneten Halterahmen (11) für den Adapter (13) und die Prüfeinrichtung (12),
mit einer beweglichen Tragplatte (24) zur Aufnahme der Leiterplatte (6), auf der die Leiterplatte (6) mittels einer ersten Zentriervorrichtung (40) zentrierbar ist, wobei die Tragplatte (24) mittels eines wenigstens ein bewegliches Förderelement (32) aufweisenden Förderes (20) von einer Eingabestelle (22) zur Prüfstelle (21) in eine vorpositionierte Position förderbar ist, und
mit einer zweiten Zentriervorrichtung (53) für die Tragplatte im Bereich der Prüfstelle,
**dadurch gekennzeichnet**,
daß mit der zweiten Zentriervorrichtung (53) sowohl die Tragplatte (24) als auch der Adapter (13) gegenüber der elektronischen Prüfeinrichtung (12) ausrichtbar sind.

2. Gerät nach Anspruch 1,
dadurch gekennzeichnet,
daß die zweite Zentriervorrichtung (53) durch einen vertikal verschiebbaren ersten Zentrierbolzen unrunden Querschnitts oder zwei vertikal verschiebbare erste Zentrierbolzen (55) gebildet ist, die jeweils Zentrierschrägen (kegelförmige Anspitzungen) aufweisen und in ein Zentrierloch (56) entsprechenden Querschnitts in der Tragplatte (24) einschiebbar und wieder zurückschiebbar sind.

3. Gerät nach Anspruch 1 oder 2,
dadurch gekennzeichnet,
daß die erste Zentriervorrichtung (40) durch vorzugsweise zwei an der Tragplatte (24) befestigte Zapfen (25) vorzugsweise runden Querschnitts und zugehörige in der Leiterplatte (6) vorgesehene Zentrierlöcher (26) entsprechenden Querschnitts gebildet sind.

4. Gerät nach einem der Ansprüche 1 bis 3,
dadurch gekennzeichnet,
daß die ersten Zentrierbolzen (55) einen zylindrischen Querschnitt aufweisen und kegelförmig angespitzt sind.

5. Gerät nach einem der Ansprüche 1 bis 4,
dadurch gekennzeichnet,
daß die ersten Zentrierbolzen (55) durch wenigstens eine hydraulische oder pneumatische Zylinderkolbeneinheit (54) verschiebbar sind.

6. Gerät nach einem der Ansprüche 1 bis 5,
dadurch gekennzeichnet,
daß die ersten Zentrierbolzen (55) auch den Adapter (13) in darin vorgesehenen Zentrierlöchern (65) durchfassen.

7. Gerät nach einem der Ansprüche 1 bis 6,
dadurch gekennzeichnet,
daß die ersten Zentrierbolzen (55) an der Rückseite des Halterahmens (11) bzw. der Tragplatte (24) angeordnet sind.

8. Gerät nach einem der Ansprüche 1 bis 7,
dadurch gekennzeichnet,
daß der Adapter (13) in eine schubladenförmige Führung (45) einschiebbar ist.

9. Gerät nach Anspruch 8,
dadurch gekennzeichnet,
daß die Führung (45) vorzugsweise hydraulisch oder pneumatisch hebbar und senkbar und in ihrer angehobenen Stellung zentrierbar und fixierbar ist.

10. Gerät nach Anspruch 8 oder 9,
dadurch gekennzeichnet,
daß zur Zentrierung der Führung (45) bzw. des Adapters (13) zusätzlich zwei vertikal verschiebbare zweite Zentrierbolzen (48) vorgesehen sind, die in Zentrierlöcher (65 bzw. 51) entsprechenden Querschnitts im Adapter (13) einschiebbar und wieder zurückschiebbar sind.

11. Gerät nach Anspruch 10,
dadurch gekennzeichnet,
daß die zweiten Zentrierbolzen (48) ebenfalls einen zylindrischen Querschnitt aufweisen und kegelförmig angespitzt sind.

12. Gerät nach Anspruch 10 oder 11,
dadurch gekennzeichnet,
daß die zweiten Zentrierbolzen (48) diagonal zum Halterahmen (11) angeordnet sind.

13. Gerät nach einem der Ansprüche 1 bis 12,
dadurch gekennzeichnet,
daß der Adapter (13) aus wenigstens zwei übereinander angeordneten Führungsplatten besteht und die Zentrierlöcher (65) in der untersten Führungsplatte (66) sowie die Zentrierlöcher (56) in der Tragplatte (24) zusammen gebohrt sind.

14. Gerät nach einem der Ansprüche 1 bis 13,
dadurch gekennzeichnet,
daß die Zylinderkolbeneinheiten (54) für die ersten Zentrierbolzen (55), die Zylinderkolbeneinheiten (49) für die zweiten Zentrierbolzen (48) und/oder die Zylinderkolbeneinheiten (47) für die Führungsleisten (46) an einer Trägerplatte (57) fixiert sind.

15. Gerät nach einem der Ansprüche 1 bis 14,
dadurch gekennzeichnet,
daß der Förderer (20) durch ein, vorzugsweise wenigstens zwei parallel angeordnete Förderbänder (32) gebildet ist.

16. Gerät nach Anspruch 15,
dadurch gekennzeichnet,
daß das oder die Förderbänder (32) um Räder oder Rollen (31) umlaufende Förderbänder sind.

17. Gerät nach einem der Ansprüche 1 bis 16,
dadurch gekennzeichnet,
daß im Bereich der Prüfstelle (21) unterhalb der Tragplatte (24) wenigstens ein vertikal verschiebbares Druckstück (34) angeordnet ist.

18. Gerät nach Anspruch 17,
dadurch gekennzeichnet,
daß das Druckstück (34) durch ein Druckglied (38) hochschiebbar ist, das vorzugsweise mittig auf eine unterhalb des Druckstücks (34) angeordnete Druckplatte (36) wirkt, wobei zwischen dieser Druckplatte (36) und dem Druckstück (34, 35) elastische Glieder, vorzugsweise in Form von Druckbälgen (37) angeordnet sind.

19. Gerät nach Anspruch 17 oder 18,
dadurch gekennzeichnet,
daß das Druckstück durch mehrere, sich längs des wenigstens einen Förderbandes (32) erstreckende Druckleisten (34) gebildet ist.

20. Gerät nach einem der Ansprüche 1 bis 19,
dadurch gekennzeichnet,
daß der Eingabestelle (22) zu beiden Seiten Vorpositionierungs-Punkte oder -Kanten (28) zugeordnet sind, zwischen denen die Tragplatte (24) mit Spiel aufnehmbar ist.

21. Gerät nach einem der Ansprüche 1 bis 20,
dadurch gekennzeichnet,
daß der Prüfstelle (21) wenigstens ein Anschlag (43) für die Tragplatte (24) zugeordnet ist.

22. Gerät nach Anspruch 21,
dadurch gekennzeichnet,
daß der Tragplatte (24) im Bereich der Prüfstelle (21) ein Niederhalter oder Abstreifer (44) zugeordnet ist.

23. Gerät, insbesondere nach einem der Ansprüche 1 bis 22,
dadurch gekennzeichnet,
daß der Halterahmen (11) hochklappbar angeordnet ist.

24. Gerät nach Anspruch 23,
dadurch gekennzeichnet,
daß der Halterahmen (11) um eine parallel zur Förderrichtung (23) verlaufende seitliche Achse (14) schwenkbar ist.

25. Gerät nach Anspruch 23 oder 24,
dadurch gekennzeichnet,
daß der Halterahmen (11) in seiner heruntergeklappten Arbeitsstellung auf seiner der Achse (14) abgewandten Seite durch Zentrier- und Fixierelemente (17) zentriert und fixiert ist.

26. Gerät nach Anspruch 25,
dadurch gekennzeichnet,
daß ein, vorzugsweise zwei hydraulisch oder pneumatisch beaufschlagbare Zentrier- und Fixierzapfen (17) vorgesehen sind.

## Claims

1. Apparatus for testing on and/or off grid test points of a printed circuit board by means of an exchangeable adapter (13) which, during the testing, is arranged between contact elements (62) of an electronic testing device (12) and the printed circuit board (6) at a testing position (21),
having a table shaped receiving device (5) for the printed circuit board (6),
having a holding frame (11), arranged above the receiving device, for the adapter (13) and the testing device (12), having a movable carrier plate (24) for receiving the printed circuit board (6) on which the printed circuit board (6) can be centred by means of a first centering device (40), the carrier plate (24) being conveyable by means of a conveyor (20) having at least one movable conveying element (32) from an insertion position (22) to the testing position (21) into a pre-positioned location, and
having near the testing position (21) a second centering device (53) for the carrier plate (24),
characterised in that,
with the second centering device (53), both the carrier plate (24) and the adapter (13) can be aligned with respect to the electronic testing device (21).

2. Apparatus according to claim 1,
characterised in that,
the second centering device (53) comprises one vertically displaceable first centering pin with a non-circular cross-section, or two vertically displaceable first centering pins (55) which each have centering slopes (conical points), which can each be inserted into and removed from a centering hole (56) of corresponding cross-section in the carrier plate (24).

3. Apparatus according to claim 1 or claim 2,
characterised in that,
the first centering device (40) is formed preferably by two pins (25) fixed to the carrier plate (24), preferably of circular cross-section, and associated centering holes (26) of corresponding cross-section in the printed circuit board (6).

4. Apparatus according to any one of claims 1 to 3,
characterised in that,
the first centering pins (55) have a cylindrical cross-section and have conical tips.

5. Apparatus according to any one of claims 1 to 4,
characterised in that,
the first centering pins (55) are displaceable by at least one hydraulic or pneumatic piston-cylinder unit (54).

6. Apparatus according to any one of claims 1 to 5,
characterised in that,
the first centering pins (55) also pass through centering holes (65) provided in the adapter (13).

7. Apparatus according to any one of claims 1 to 6,
characterised in that,
the first centering pins (55) are arranged at the back of the holding frame (11) or the carrier plate (24).

8. Apparatus according to any one of claims 1 to 7,
characterised in that,
the adapter (13) can be inserted in a guide (45) in the form of a drawer.

9. Apparatus according to claim 8,
characterised in that,
the guide (45) can be raised or lowered and centred and fixed in its raised position preferably hydraulically or pneumatically.

10. Apparatus according to claim 8 or 9,
characterised in that,
for centering the guide (45) or the adapter (13) as the case may be, two vertically displaceable second centering pins (48) are additionally provided which can be pushed into and withdrawn from centering holes (65 and 51 respectively) of corresponding cross-section in the adapter (13).

11. Apparatus according to claim 10,
characterised in that,
the second centering pins (48) also have a cylindrical cross-section and have conical tips.

12. Apparatus according to claim 10 or 11,
characterised in that,
the second centering pins (48) are arranged diagonally to the holding frame (11).

13. Apparatus according to any one of claims 1 to 12,
characterised in that,
the adapter (13) comprises at least two superimposed guide plates and the centering holes (65) in the lowest guide plate (66) and the centering holes (56) in the carrier plate (24) are drilled together.

14. Apparatus according to any one of claims 1 to 13,
characterised in that,
the piston-cylinder units (54) for the first centering pins (55), the piston-cylinder units (49) for the second centering pins (48) and/or the piston cylinder units (47) for the guide rails (46) are fixed to a carrier plate (57).

15. Apparatus according to any one of claims 1 to 14,
characterised in that,
the conveyor (20) comprises a conveyor belt or preferably at least two conveyor belts (32) arranged parallel to one another.

16. Apparatus according to claim 15,
characterised in that,
the conveyor belt or belts (32) is or are conveyor belts which run round wheels or rollers (31).

17. Apparatus according to any one of claims 1 to 16,
characterised in that,
near the testing position (21) at least one vertical displaceable pressure piece (34) is arranged underneath the carrier plate (24).

18. Apparatus according to claim 17,
characterised in that,
the pressure piece (34) can be pushed up by a pressure member (38) which acts, preferably in the middle, on a pressure plate (36) located underneath the pressure piece (34), and in that elastic members, preferably in the form of pressure bellows (37), are arranged between this pressure plate (36) and the pressure piece (34, 35).

19. Apparatus according to claim 17 or 18,
characterised in that,
the pressure piece comprises a plurality of pressure rails (34) extending along the length of at least one conveyor belt (32).

20. Apparatus according to any one of claims 1 to 19,
characterised in that,
on both sides of the insertion position (22) there are pre-positioning points or edges (28) between which the carrier plate (24) can be received with some clearance.

21. Apparatus according to any one of claims 1 to 20,
characterised in that,
the testing position (21) has at least one stop (43) for the carrier plate (24).

22. Apparatus according to claim 21,
characterised in that,
the carrier plate (24) has a clamp or stripper (44) arranged near the testing position (21).

23. Apparatus, in particular according to any one of claims 1 to 22,
characterised in that,
the holding frame (11) can be swung upwards.

24. Apparatus according to claim 23,
characterised in that,
the holding frame (11) can be swivelled about an axis (14) situated on one side and parallel to the direction of the conveyor (23).

25. Apparatus according to claim 23 or 24,
characterised in that,
in its swung-down operational position the holding frame (11) is centred and fixed by centering and fixing elements (17) on the side facing away from its axis (14).

26. Apparatus according to claim 25,
characterised in that,
one, and preferably two, hydraulically or pneumatically driven centering and fixing pins (17) are provided.

## Revendications

1. Appareil pour le contrôle de points de contrôle disposés en réseau et/ou hors réseau d'une carte à circuit imprimé au moyen d'un dispositif d'adaptation (13) qui, lors du contrôle, est placé entre des organes de contact (62) d'un dispositif de contrôle (12) électronique et la carte à circuit imprimé (6) se trouvant à un poste de contrôle (21), appareil comportant un dispositif de réception (5) en forme de table pour la carte à circuit imprimé (6), un cadre porteur (11) pour le dispositif d'adaptation (13) et le dispositif de contrôle (12) qui est disposé au-dessus du dispositif de réception, un plateau porteur (24) mobile recevant la carte à circuit imprimé (6), sur lequel ladite carte à circuit imprimé (6) est centrée au moyen d'un premier dispositif de centrage (40), le plateau porteur (24) étant amené par un dispositif de transport (20) comportant au moins un organe de transport (32) mobile d'un poste de chargement (22) vers un poste de contrôle (21) dans une position préétablie, et un deuxième dispositif de centrage (53) du plateau porteur (24) dans la région du poste de contrôle (21), caractérisé par le fait que le deuxième dispositif de centrage (53) permet de psotionner aussi bien le plateau porteur (24) que le dispositif d'adaptation (13) par rapport au dispositif de contrôle (12) électronique.

2. Appareil selon la revendication 1, caractérisé par le fait que le deuxième dispositif de centrage (53) est constitué par une première broche de centrage de section non circulaire mobile verticalement ou par deux premières broches de centrage (55) mobiles verticalement qui comportent chacune des surfaces de centrage inclinées (extrémités coniques) et s'engagent avec possibilité de retrait dans un trou de centrage (56) de section adaptée prévu dans le plateau porteur (24).

3. Appareil selon la revendication 1 ou 2, caractérisé par le fait que le premier dispositif de centrage (40) est constitué de préférence par deux tourillons (25), de préférence de section circulaire, fixés sur le plateau porteur (24) et par des trous de centrage (26) de section adaptée prévus dans la carte à circuit imprimé (6).

4. Appareil selon l'une des revendications 1 à 3, caractérisé par le fait que les premières broches de centrage (55) ont une section cylindrique et comportent une extrémité pointue conique.

5. Appareil selon l'une des revendications 1 à 4, caractérisé par le fait que les premières broches de centrage (55) sont déplacées par au moins un ensemble piston-cylindre (54) hydraulique ou pneumatique.

6. Appareil selon l'une des revendications 1 à 5, caractérisé par le fait que les premières broches de centrage (55) traversent également le dispositif d'adaptation (13) par des trous de centrage (65) prévus dans ce dernier.

7. Appareil selon l'une des revendications 1 à 6, caractérisé par le fait que les premières broches de centrage (55) sont montées sur le côté arrière du cadre porteur (11) ou du plateau porteur (24).

8. Appareil selon l'une des revendications 1 à 7, caractérisé par le fait que le dispositif d'adaptation (13) peut être introduit dans un dispositif de guidage (45) de type tiroir.

9. Appareil selon la revendication 8, caractérisé par le fait que le dispositif de guidage (45) peut être relevé et abaissé de préférence par des moyens hydrauliques ou pneumatiques et peut être centré et bloqué en position relevée.

10. Appareil selon la revendication 8 ou 9, caractérisé par le fait qu'il est prévu en plus, pour le centrage du dispositif de guidage (45) ou du dispositif d'adaptation (13), deux deuxièmes broches de centrage (48) mobiles verticalement qui s'engagent avec possibilité de retrait dans des trous de centrage (65 ou 51) de section adaptée aménagés dans le dispositif d'adaptation (13).

11. Appareil selon la revendication 10, caractérisé par le fait que les deuxièmes broches de centrage (48) ont également une section circulaire et présentent une extrémité conique.

12. Appareil selon la revendication 10 ou 11, caractérisé par le fait que les deuxièmes broches de centrage (48) sont disposées en diagonale par rapport au cadre porteur (11).

13. Appareil selon l'une des revendications 1 à 12, caractérisé par le fait que le dispositif d'adaptation (13) est constitué par au moins deux plaques de guidage disposées l'une au-dessus de l'autre et que les trous de centrage (65) dans la plaque de guidage (66) inférieure et les trous de centrage (56) dans le plateau porteur (24) sont percés simultanément.

14. Appareil selon l'une des revendications 1 à 13, caractérisé par le fait que les ensembles piston-cylindre (54) pour les premières broches de centrage (55), les ensembles piston-cylindre (49) pour les deuxièmes broches de centrage (48) et/ou les ensembles piston-cylindre (47) pour les barrettes de guidage (46) sont montés sur un plateau support (57).

15. Appareil selon l'une des revendications 1 à 14, caractérisé par le fait que le dispositif de transport (20) est constitué par une, de préférence au moins deux bandes transporteuses (32) parallèles.

16. Appareil selon la revendication 15, caractérisé par le fait que la ou les bandes transporteuse(s) (32) est(sont) une(des) bande(s) transporteuse(s) qui circule(nt) sur des roues ou des galets (31).

17. Appareil selon l'une des revendications 1 à 16, caractérisé par le fait qu'au moins un élément presseur (34) mobile verticalement est disposé dans la région du poste de contrôle (21) en-dessous du plateau porteur (24).

18. Appareil selon la revendication 17, caractérisé par le fait que l'élément presseur (34) peut être déplacé vers le haut par un organe de pression (38) qui agit de préférence au centre d'un plateau de pression (36) disposé sous l'élément presseur (34), des éléments élastiques qui se présentent de préférence sous la forme de soufflets de pression (37) étant disposés entre ledit plateau de pression (36) et l'élément presseur (34, 35).

19. Appareil selon la revendication 17 ou 18, caractérisé par le fait que l'élément presseur est formé de plusieurs barrettes de pression (34) qui s'étendent le long de la bande transporteuse (32) au nombre d'au moins une.

20. Appareil selon l'une des revendications 1 à 19, caractérisé par le fait que des points ou des bords de pré-positionnement (28), entre lesquels le plateau porteur (24) est reçu avec jeu, sont disposés de part et d'autre du poste de chargement (22).

21. Appareil selon l'une des revendications 1 à 20, caractérisé par le fait qu'au moins une butée (43) pour le plateau porteur (24) est associée au poste de contrôle (21).

22. Appareil selon la revendication 21, caractérisé par le fait qu'un dispositif de serrage ou un extracteur (44) est associé au le plateau porteur (24) dans la région du poste de contrôle (21).

23. Appareil notamment selon l'une des revendications 1 à 22, caractérisé par le fait que le cadre porteur (11) est agencé de manière à pouvoir être relevé.

24. Appareil selon la revendication 23, caractérisé par le fait que le cadre porteur (11) peut pivoter autour d'un axe latéral (14) parallèle à la direction de transport (23).

25. Appareil selon la revendication 23 ou 24, caractérisé par le fait que le cadre porteur (11), dans sa position de travail rabattue vers le bas, est centré et bloqué du côté opposé à son axe (14) par des éléments de centrage et de positionnement (17).

26. Appareil selon la revendication 25, caractérisé par le fait qu'il est prévu une, de préférence deux broches de centrage et de positionnement (17) qui sont commandées par des moyens hydrauliques ou pneumatiques.
